# EUROPEAN PATENT APPLICATION

(11) **EP 1 860 696 A1**
(43) Date of publication of application: **28.11.2007**
(21) Application number: 06405235.0
(22) Date of filing: 26.05.2006
(51) Int. Cl.: H01L 23/48, H01L 25/07

(54) **Semiconductor module**

(71) Applicant: ABB RESEARCH LTD., 8050 Zürich (CH)
(72) Inventor: Knapp, Wolfgang, 5600 Lenzburg (CH); Häderli, Christoph, 8047 Zürich (CH)
(74) Representative: ABB Patent Attorneys

(57) **Abstract**

A semiconductor subassembly comprises at least two semiconductor chips (2, 2') and a first and a second conductive plate (3, 4). The semiconductor chips (2, 2') are thermally connected on their main electrode sides to the first and second conductive plate (3, 4). The semiconductor subassembly (13) comprises at least one through hole (7), which penetrates the conductive plates (3, 4) and the plane, in which the at least two semiconductor chips (2, 2') are arranged. The subassembly (13) is pressable by a compression means (8), whereby the compression means (8) can be arranged in the through hole (7).

## Description

### Technical Field

The invention relates to the field of high power electronics and more particularly to a semiconductor subassembly, a semiconductor module and a power electronic system according to the preamble of the independent claims.

### Background Art

US 2004/0070060 shows a semiconductor module with two semiconductor chips comprising two main electrode sides opposite of each other. Each of the chips is thermally and electrically connected to radiation members on both main electrode sides. These radiation members are formed with protruding portions, having flat front ends, at which the main electrodes of the chips are connected. Both radiation members are covered by main electrode plates, which are thermal and electrical contact to the radiation members. The main electrode plates with the radiation members and the semiconductor chips are sandwiched between two cooling members with plate-shaped thermally conducting, but electrical insulating insulation substrates interposed there between. The cooling members are compressed by at least two screws, which press the cooling members together at the side. As at least two screws are needed there is a danger of tilting of the compressed elements or of bending of the cooling members. In both cases the thermal contact between the chips and the cooling members is strongly reduced. In order to reduce the danger of bending stiff radiation members are needed, which increase the weight of the system, because in order to achieve stiff plates the plate have to be thick. As the cooling members are insulated from the chips, they cannot be used as main electrode plates and additional main electrode plates are necessary.

### Disclosure of Invention

It is an object of the invention to provide a compact press packed semiconductor subassembly with semiconductor chips and conductive plates to both main sides of the semiconductor chips, which subassembly is compressible by a simple compression means.

This object is achieved by a semiconductor subassembly according to claim 1.

The inventive semiconductor subassembly comprises at least two semiconductor chips and a first and a second conductive plate. Each chip has a first and a second main electrode side opposite of each other. The first conductive plate, which is arranged on the first main electrode side, and the second conductive plate, which is arranged on the second main electrode side, are thermally and electrically contacted to the at least two semiconductor chips.

The inventive semiconductor subassembly is characterized in that the subassembly comprises a through hole, which penetrates the first and second conductive plate and the plane, in which the at least two semiconductor chips are arranged. The subassembly can be pressed by a compression means, which compression means can be arranged in the through hole. Such a semiconductor subassembly is easy to manufacture and the subassembly is prepared to be easily compressed.

Another embodiment of the invention concerns a semiconductor module with an inventive semiconductor subassembly as disclosed above and a compression means. The compression means is cheap and it can be of simple construction. The semiconductor module can be compressed by merely one compression means and the compression means is easy to install. In a preferred embodiment the pressure is applied in an area stretched between the at least two semiconductor chips. Thus, the pressure distribution is advantageous, because pressure is applied more uniformly to the semiconductor chips and the tendency for the compressed parts to tilt is minimized. Such a compression means allows premounting of semiconductor modules for a semiconductor device, so that these semiconductor modules can be tested alone and the completion of the whole semiconductor device is fast. That is also advantageous for repair and maintenance purposes, because the demounting of the module is quick, faults can easily be located because of the modular design and the semiconductor modules can easily be exchanged. The through hole together with the compression means can also be used for alignment purposes. If one compression means is used, only alignment in rotational direction is needed, if more than one compression means are used, the parts of the semiconductor module are self-aligned.

### Brief Description of Drawings

The subject matter of the invention will be explained in more detail in the following text with reference to the attached drawings, in which:
FIG 1 shows a cross sectional view of a semiconductor subassembly according to the invention;
FIG 2 shows a perspective view to a premounted semiconductor subassembly according to the invention;
FIG 3 shows a top view to another premounted semiconductor subassembly according to the invention with two semiconductor chips;
FIG 4 shows a top view to a premounted semiconductor subassembly according to the invention with four semiconductor chips;
FIG 5 shows a top view of another premounted semiconductor subassembly according to the invention with four semiconductor chips;
FIG 6 shows a top view of another premounted semiconductor subassembly according to the invention with four semiconductor chips;
FIG 7 shows a cross sectional view of another semiconductor subassembly according to the invention;
FIG 8 shows a perspective view to another premounted semiconductor subassembly according to the invention;
FIG 9 shows a cross sectional view of a semiconductor module according to the invention;
FIG 10 shows a cross sectional view of another semiconductor module according to the invention;
FIG 11 shows a cross sectional view of another semiconductor module according to the invention; and
FIG 12 shows a cross sectional view of another semiconductor module according to the invention.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

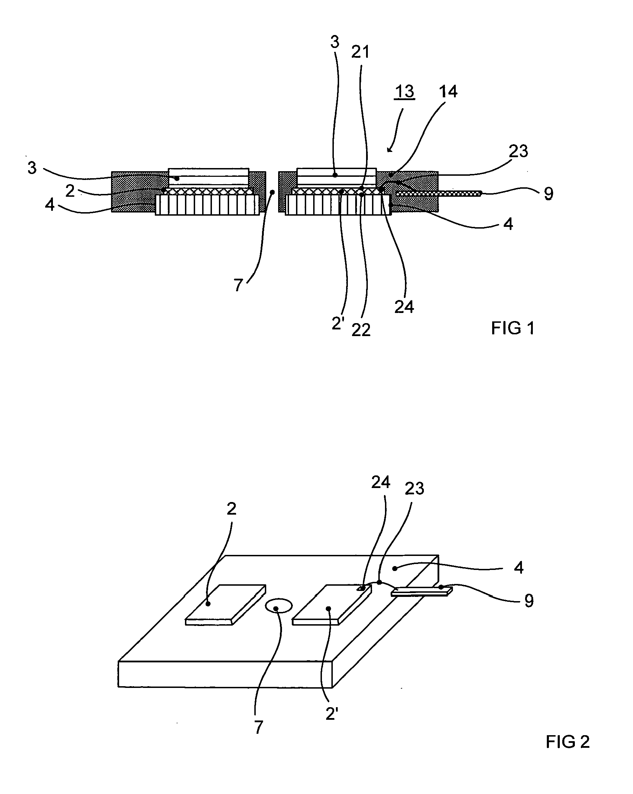

In FIG 1 a semiconductor subassembly 13 according to the invention is shown. The semiconductor subassembly 13 comprises at least two semiconductor chips 2, 2', each of which chips has a first 21 and a second 22 main electrode side opposite of each other. Semiconductor chip 2' in FIG 1, typically a switch like an IGBT or a FET, comprises a gate electrode 24, which is electrically connected by a gate connection 23 to an electrical connector 9, typically in the form of a lead frame. Semiconductor chip 2 in FIG 1 has no gate electrode and is typically a diode. Of course, any kind of semiconductor chips 2, 2' can be used. Each semiconductor chip 2, 2' is in electrical and thermal contact with a first conductive plate 3, which is arranged on the first main electrode side 21 of each semiconductor chip 2, 2', and with a second conductive plate 4, which is arranged on the second main electrode side 22. The first and second conductive plates 3, 4 and the at least two semiconductor chips 2, 2' in between form the subassembly 13. Typically, the electrical connection of the first and/or second conductive plate 3, 4 is made by external connector, electrically connected to the conductive plates 3, 4 on the sides opposite the sides on which the semiconductor chips 2, 2' are arranged, so that large current and high potential can be applied to the semiconductor chips 2, 2'.

In a preferred embodiment of the invention each of the semiconductor chips 2, 2' is mechanically firmly connected to at least one of the conductive plates 3, 4. That means that the at least two semiconductor chips 2, 2' are mechanically firmly connected on their first main electrode side 21 to the first conductive plate 3 or on their second main electrode side 22 to the second conductive plate 4. The firmly mechanical connection can for example be achieved by bonding, glueing or sintering.

The subassembly 13 comprises a through hole 7, which penetrates the first conductive plate 3, the plane, in which the semiconductor chips 2, 2' are arranged, and the second conductive plate 4. In FIG 1, the through hole 7 penetrates the plane, in which the at least two semiconductor chips 2, 2' are arranged, within an area stretched between the at least two semiconductor chips 2, 2', but the through hole 7 can also be arranged at onother place, e.g. if it is advantageous because of construction reasons.

The inventive semiconductor assembly 13 may additionally comprise an insulator 14, which surrounds the at least two semiconductor chips 2, 2' in a region perpendicular to the main electrode sides 21, 22. In Fig. 1 the insulator 14 also surrounds the first and second conductive plates 3, 4 and insulates the semiconductor chips 2, 2' in the region of the through hole 7.

The insulator 14 can be a moulded insulator and it can e.g. be made from a hardened resin. As shown in FIG. 1, the conductive plates 3, 4 typically extend the insulator 14 in the direction perpendicular to the main electrode sides 21, 22, so that no stress arises when the subassembly gets warm during operation.

The subassembly 13 can be pressure clamped by a compression means 8 (not shown in Fig. 1) which typically comprises an elastical element 81 and a connection element 82, the connection element 82 being arranged in the through hole 7. The insulator 14 may comprise means for enhancing the creepage distance to such a connection means 82. Such means can be projecting insulating parts, by which the insulator 14 extends beyond the plane(s), in which the first and/or second conductive plates 3, 4 are arranged in the area adjacent to the connection means 82. Other means for enhancing the creepage distance are an increased thickness of the insulator 14 in the area adjacent to the connection means 82 or groves, which are arranged on the surface of the insulator 14, which surface lies parallel to the main electrode sides 21, 22, and the groves are arranged around the connection means 82. Those means can also be combined, e.g. by having an insulator 14 with projecting portions and grooves.

FIG 2 shows a perspective view to a premounted semiconductor subassembly 13 with a second conductive plate 4, two semiconductor chips 2, 2' and a through hole 7. From this view it can easily be seen that the second conductive plate 4 is one continuous plate. The first conductive plate 3 is also a continuous plate (not shown in FIG 2).

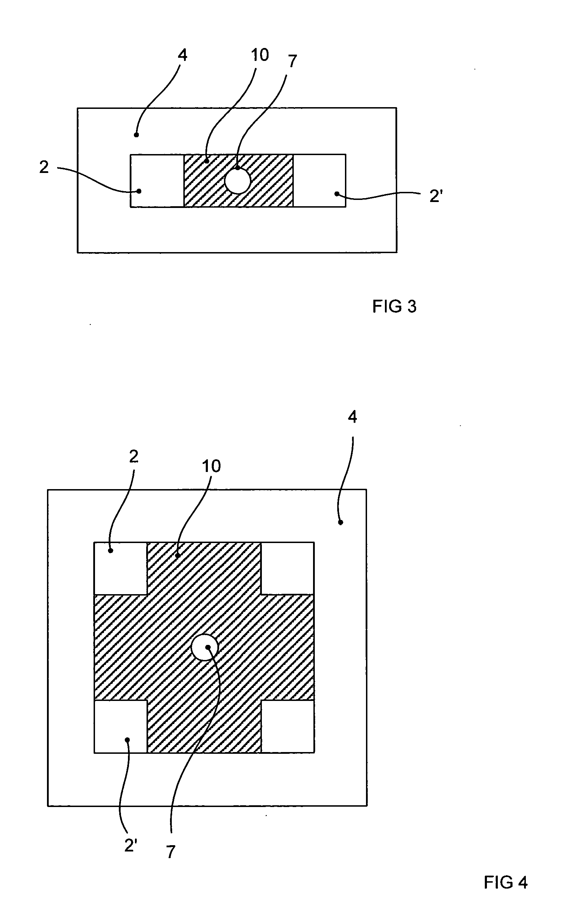

FIG 3 shows another embodiment of an inventive semiconductor subassembly 13 in a top view. The second conductive plate 4 is shown with two semiconductor chips 2, 2' on top of it. The through hole 7 is arranged within an area 10 stretched between the two semiconductor chips 2, 2' (emphasized in the figure by the hatched area). Preferably, the through hole 7 is arranged on the centerline of the two semiconductor chips 2, 2', in particular in the balance point of the two semiconductor chips 2, 2', because then a very homogeneous pressure distribution is achieved, but the through hole 7 can also be arranged anywhere within the area 10. That can be advantageous for construction reasons. Any of the at least two semiconductor chips 2, 2' can be connected to a gate electrode (not shown in FIG 3).

FIG 4 to 6 show top views of other embodiments of the inventive subassembly 13, which comprise more than two semiconductor chips 2, 2'. In FIG 4 a premounted semiconductor subassembly 13 with four semiconductor chips 2, 2' is shown. The area 10 stretched between the four semiconductor chips 2, 2' is emphasized in the figure by the hatched area. In FIG 4 the through hole 7 is arranged within the area 10, in particular in the balance point of the chips 2, 2'.

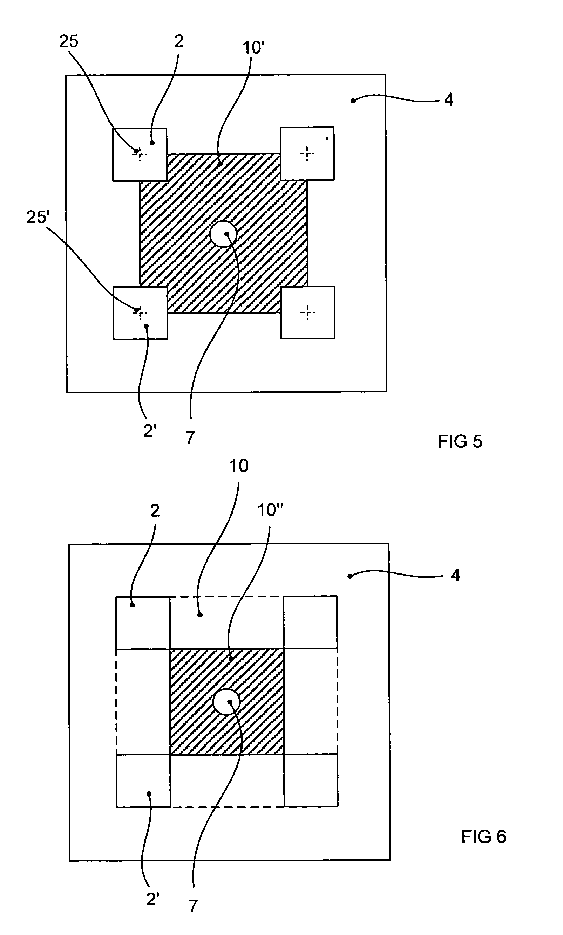

In FIG 5 a premounted semiconductor subassembly 13 with four semiconductor chips 2, 2' is shown. The through hole 7 is arranged within the area 10' stretched between the centres 25, 25' of the four semiconductor chips 2, 2'. The area 10' is emphasized in the figure by the hatched area.

In FIG 6 an inventive premounted semiconductor subassembly 13 with four semiconductor chips 2, 2' is shown. The through hole 7 is arranged within the area 10" stretched between the four semiconductor chips 2, 2', but excluding those areas, which lie on the border of the area 10 (dashed line) and which are stretched between two neighbouring semiconductor chips (2, 2'), in particular between two directly neighbouring semiconductor chips (2, 2'). With directly neighbouring semiconductor chips 2, 2' it is meant that no other semiconductor chip lies between the directly neighbouring chips 2, 2'. The area 10" is emphasized in the figure by the hatched area.

Of course the semiconductor assembly may also comprise any other number of semiconductor chips 2, 2' and may also comprise more than one through hole 7. For example, for an arrangement of eight semiconductor chips 2, 2', which are arranged in two rows, there could be two through holes 7, one of the through holes 7 arranged in the balance point of four semiconductor chips 2, 2' on one side and the other through hole 7 arranged in the balance point of the other four semiconductor chips 2, 2'.

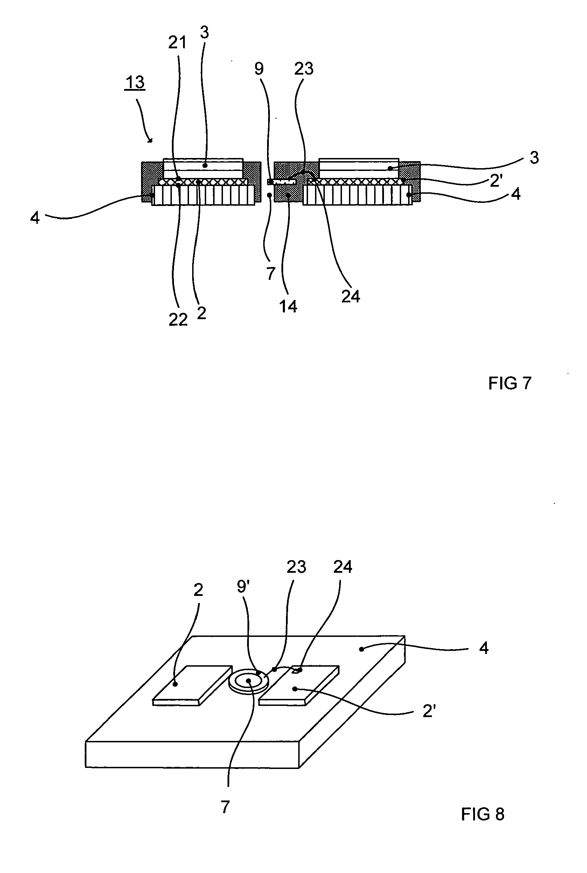

In FIG 7 another preferred embodiment of the inventive subassembly 13 is shown. The subassembly 13 comprises at least one semiconductor chips 2' with a gate electrode 24. The at least two semiconductor chips 2, 2' are surrounded by an insulator 14 in the region perpendicular to the main electrode sides 21, 22. The gate electrode 24 is electrically connected by a gate connection 23, which is connected by an electrical connector 9 and lead to the through hole 7. The electrical connector 9 can be electrically connected externally through the through hole 7.

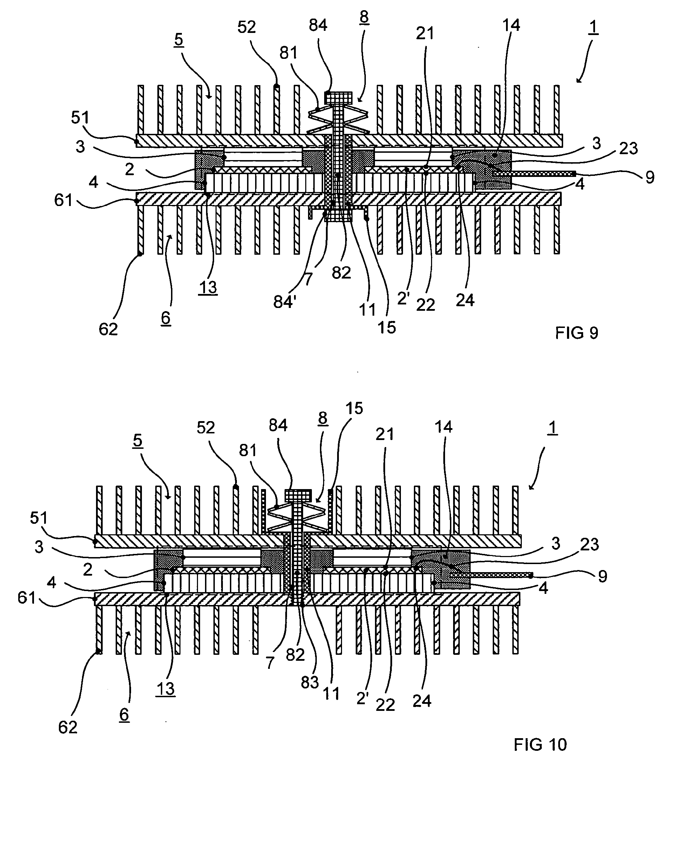

FIG 8 shows a perspective view on a semiconductor subassembly with an electrical connector 9', which is lead to the through hole 7. The electrical connector 9' surrounds the hole 7, in FIG 8 the electrical connector 9' is in form of a electrical conductive ring. By such a ring an external electrical connection of the gate electrode 24 can easily be realised by an electrical plug, which is in electrical contact with the electrical connector 9' on a large, circular area.

In FIG 9 a preferred embodiment of the inventive semiconductor module 1 is shown. The semiconductor module 1 comprises a semiconductor subassembly 13 as described above and a compression means 8, by which the subassembly 13 is pressure clamped. The compression means 8 comprises an elastical element 81 and a connection element 82, the connection element 82 being arranged in the through hole 7. The connection means 82 extends the through hole 7 by extending parts and has lateral protruding portions 84, 84' on these extending parts. The elastical element 81 in FIG 9 is arranged between the protruding portion 84 of the connection means 82 and the first conductive plate 3. It is compressed, so that the first and second conductive plates 3, 4 with the semiconductor chips 2, 2' in between are compressed. The elastical element 81 can be a spring, e.g. an elastomer, polymer, plastic, metal or gas spring or a spring washer. The compression means 8 shown in FIG 9 comprises only one spring. In that case, the other protruding portion 84' can be directly pressed against the second conductive plate 4. It is also possible that the compression means 8 comprises more than one elastical elements 81. In that case the springs can be arranged between each of the protruding portions 84, 84' of the connection means 82 and the conductive plates 3, 4.

In another preferred embodiment, the elastical element 81 is electrically insulated against the first and/or second conductive plate 3, 4 and/or the semiconductor chips 2, 2' by an insulation element 11. Alternatively, the elastical element 81 may be made of an electrically insulating material or at least covered by an insulating material. Alternatively, the elastical element 81 is on the same electrical potential as the conductive plate 3 or 4, respectively.

The semiconductor module 1 as shown in FIG 9 further comprises a first cooling device 5 with a first cooling plate 51 and first cooling fins 52. The first cooling plate 51 in FIG 9 is in electrical and thermal contact with the first conductive plate 3 on that side of plate 3, which is opposite the side, at which the semiconductor chips 2, 2' are arranged. Furthermore, the semiconductor module 1 comprises a second cooling device 6 with a second cooling plate 61 and second cooling fins 62. The second cooling plate 61 is in electrical and thermal contact with the second conductive plate 4 on that side of plate 4, which is opposite the side, at which the semiconductor chips 2, 2' are arranged. In an alternative, the first cooling device 5 only consists of a first cooling plate and/or the second cooling device 6 consists only of a second cooling plate 61. In FIG 9 the through hole 7 penetrates the first cooling plate 51, the first conductive plate 3, the plane, in which the semiconductor chips 2, 2' are arranged, the second conductive plate 4 and the second cooling plate 61. An insulator 14 surrounds the at least two semiconductor chips 2, 2' in the region perpendicular to the main electrode sides 21, 22. The insulator 14 can also fill gaps in the module, e.g. between the connection means 82, the conductive plates 3, 4 and the semiconductor chips 2, 2'.

The connection element 82 in FIG 9 is a solid bolt. In another preferred embodiment, the connection element 82 is insulated against the first and/or second conductive plate 3, 4 and/or the semiconductor chips 2, 2' by an insulation element 11. The insulation element 11 can be firmly connected to the connection element 82 or can be made in form of a tube, which is inserted in the through hole 7. Additionally, means 15 can be provided for enhancing the creepage distance. The purpose of such means 15 is to enhance the surface distance between parts, which are on different potential. Such means 15 can typically be an insulating element in form of a plate or u-shaped (shown in FIG 9), which is arranged between the protruding portion of the connection element 82 and the conductive plate 3, 4 or the cooling plate 51, 61. Such means can also be formed integrally with the insulation element 11. In that case, such means can be projecting insulating parts, by which the insulation element 11 extends beyond the plane(s), in which the first and/or second conductive plates 3, 4 are arranged. Other means for enhancing the creepage distance are an increased thickness of the insulation element 11 or groves, which are arranged on the surface of the insulation element 11, which surface lies parallel to the main electrode sides 21, 22, and the groves surround the connection means 82. Those means can also be combined, e.g. by having an insulation element 11 with projecting portions and grooves.

Alternatively, the connection element 82 itself can be made of an electrically insulating material like glass fiber rods or at least covered with an insulating material.

Alternatively, the connection element 82 can be on the same potential as the first conductive plate 3, the second conductive plate 4, the gate electrode 24 or any other potential, depending on the electrical design of the module 1. The connection element 82 can also be floating potential.

In FIG 10 another embodiment of the inventive semiconductor module 1 is shown. The semiconductor module 1 comprises a semiconductor subassembly 13 and a first and second cooling device 5, 6. The inventive compression means 8 shown in FIG 10 comprises a connection means 82, which extends the through hole 7 and has a protruding portion 84 only on one extending part. The connection means 82 is firmly connected on one side with the second cooling plate 61, in FIG 3 e.g. shown by a thread 83. Other ways of a firm connection like soldering are also possible. An elastical element 81 is arranged between the protruding portion 84 of the connection means 82 and the first cooling plate 51. Alternatively, the connection element 82 is integrally formed as one piece with the second cooling plate 61. If the connection element 82 is firmly connected to one of the cooling plates 51, 61 or formed as one piece, the assembling of the semiconductor module 1 is easy, because the assembling can be done from one side. In FIG 10 means 15 for enhancing the creepage distance between the compression means 8 and the cooling device 5 are provided.

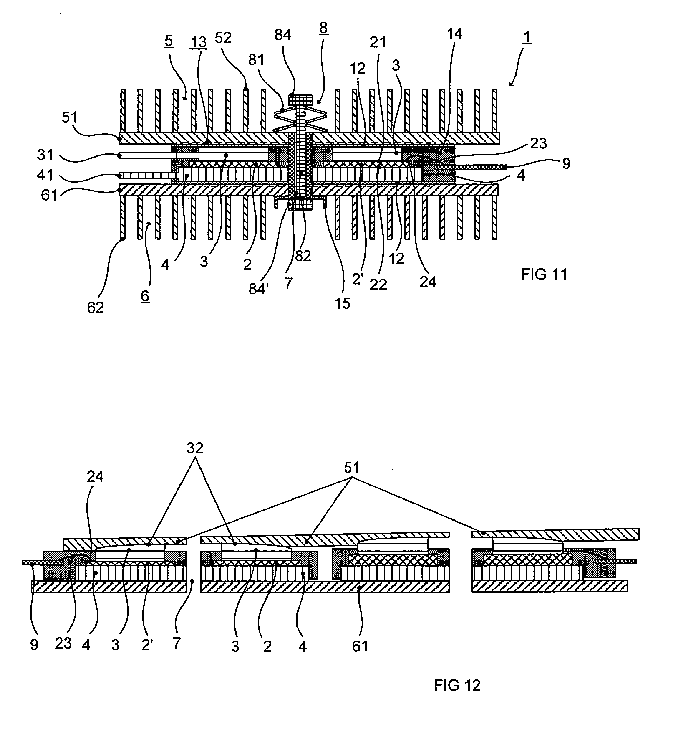

FIG 11 shows another embodiment of the semiconductor module 1 according to the invention. The semiconductor module 1 comprises a semiconductor subassembly 13 and a first and second cooling device 5, 6. The first conductive plate 3 has a first main electrode connection 31 arranged in the same plane as the first conductive plate 3 and the second conductive plate 4 has a second main electrode connection 41 arranged in the same plane as the second conductive plate 4. Between the first conductive plate 3 and the first cooling plate 51 and/or between the second conductive plate 4 and the second cooling plate 61 an insulation layer 12 is provided, so that the cooling plate 51 and/or 61 are electrically insulated against the semiconductor chips 2, 2'. In case of an insulator 14 surrounding the subassembly 13, the insulation layer 12 may be connected to the insulator 14 by a substance-to-substance connection or the insulator 14 and the insulation layer 12 may even be formed integrally as one piece. Depending on the construction of the whole semiconductor module 1, e.g. in cases in which no insulated housing is provided and depending on the cooling medium, e.g. water cooling, it can be advantageous to have the cooling devices 5, 6 insulated in such a way. Obviously, such an inventive semiconductor module 1 with first and second main electrode connections 31, 41 does not necessarily comprise cooling devices 5, 6. Then the insulation layer 12 is arranged on the outside of the semiconductor subassembly 13, i.e. in case of the first conductive plate 3 being covered by an insulation layer 12, the insulation layer 12 is arranged on that side of the first conductive plate 3, which lies parallel to the main electrode sides 21, 22 and which is opposite to the side, on which the at least two semiconductor chips 2, 2' are arranged. For the second conductive plate 4 being covered by an insulation layer 12, the insulation layer 12 is arranged on that side of the second conductive plate 4, which lies parallel to the main electrode sides 21, 22 and which is opposite to the side, on which the at least two semiconductor chips 2, 2' are arranged.

In FIG 12 another preferred embodiment of the inventive semiconductor module 1 is shown. The figure shows details of the inventive semiconductor module 1 with the first and second cooling plate 51, 61, the first and second conductive plate 3, 4, four semiconductor chips 2, 2' and two through holes 7. The first conductive plate 3 shown on the left side has a spherical projecting portion 32 on the side facing the first cooling plate 51. A subassembly of the first and second conductive plates and two semiconductor chips in between on the right side have a greater height than those shown on the left side. The first conductive plate 3 shown on the right side also has a spherical projecting portion 32 on the side facing the first cooling plate 51. The first cooling plate 51, having spherical recesses, is arranged on the first conductive plates 3. The plates 51, 3 at least partially positively fit to each other, and the first cooling plate 51 is tilted against the second cooling plate 61 due to the different heights of the staples. Such a construction is advantageous, if one or more subassemblies 13 of a semiconductor chip 2 and a first and second conductive plate 3, 4 has another height than any of the other subassemblies 13. Due to the spherical projecting portions, the cooling plates 51, 61 can be tilted against each other and still a good thermal contact is ensured. Instead of spherical projecting portions or spherical recesses the first and/or second cooling plate 51, 61 may have other forms of projecting portions and/or recesses, which positively fit to the first conductive plates 3 in the compressed subassembly 13.

In another preferred embodiment, not shown in a figure, the through hole 7 and the connection element 82 are rotational symmetrical, so that the parts of the subassembly 13 can easily be mounted together and can be rotationally aligned. Alternatively, the connection element 82, which is arranged in a through hole 7, and said through hole 7 positively fit, and the cross-section of the connection element 82 is at least partially not rotation-symmetrically within said through hole 7. Preferably, the through hole 7 is rectangular, in particular square, or oval. With such a through hole 7, which is not rotation-symmetrical, the parts of the subassembly 13 are automatically aligned. Alternatively, it is possible to use additional alignment means like pins or protrusions in the conductive plates 3, 4 and/or the cooling plates 51, 61 to fix the position of the parts within the module 1 or subassembly 13 or to use at least two compression means 8, by which the parts are also automatically aligned.

A semiconductor module 1 according to the invention can be used in any kind of electronic system like a motor drive, an inverter, a rectifier, a power supply or a power factor controller.

### Reference List

- 1: semiconductor module
- 2, 2': semiconductor chip
- 21: first main electrode side
- 22: second main electrode side
- 23: gate connection
- 24: gate electrode
- 25, 25': centre
- 3: first conductive plate
- 31: first main electrode connection
- 32: spherical portion
- 4: second conductive plate
- 41: second main electrode connection
- 5: first cooling device
- 51: first cooling plate
- 52: first cooling fins
- 6: second cooling device
- 61: second cooling plate
- 62: second cooling fins
- 7: through hole
- 8: compression means
- 81, 81': elastical element
- 82, 82',: 82" connection element
- 821: opening
- 822: recess
- 83: thread
- 84: protruding portion
- 9: electrical connector
- 10, 10',: 10" area
- 11: insulation element
- 12: insulation layer
- 13: subassembly
- 14: insulator
- 15: means for enhancing creepage distance

## Claims

1. Semiconductor subassembly (13) comprising at least two semiconductor chips (2, 2'), a first conductive plate (3) and a second conductive plate (4),
each chip (2, 2') having a first (21) and a second (22) main electrode side opposite of each other,
the first conductive plate (3) being arranged on the first main electrode side (21) and being electrically and thermally contacted to the at least two semiconductor chips (2, 2'),
the second conductive plate (4) being arranged on the second main electrode side (22) and being electrically and thermally contacted to the at least two semiconductor chips (2, 2'),
**characterized in that**
the subassembly (13) comprises a through hole (7), which penetrates the first and second conductive plates (3, 4) and the plane, in which the at least two semiconductor chips (2, 2') are arranged, whereby the subassembly (13) is pressable by a compression means (8) and the compression means (8) is arrangeable in the through hole (7).

2. Semiconductor subassembly (13) according to claim 1,
**characterized in that**
the at least two semiconductor chips (2, 2') are surrounded by an insulator (14) in the region perpendicular to the main electrode sides (21, 22).

3. Semiconductor subassembly (13) according to claim 1 or 2,
**characterized in that**
the at least two semiconductor chips (2, 2') are mechanically firmly connected on their first main electrode side (21) to the first conductive plate (3) and/or the at least two semiconductor chips (2, 2') are mechanically firmly connected on their second main electrode side (22) to the second conductive plate (4).

4. Semiconductor subassembly (13) according to any of the claims 1 to 3, **characterized in that**
the through hole (7) penetrates the plane, in which the at least two semiconductor chips (2, 2') are arranged, within an area (10) stretched between the at least two semiconductor chips (2, 2').

5. Semiconductor subassembly (13) according to any of the claims 1 to 3, **characterized in that**
the semiconductor subassembly (13) comprises at least three semiconductor chips (2, 2'), which are not arranged in a line, and **in that** the through hole (7) penetrates the plane, in which the at least three semiconductor chips (2, 2') are arranged, within an area (10') stretched between the centres (25, 25') of the at least three semiconductor chips (2, 2').

6. Semiconductor subassembly (13) according to any of the claims 1 to 3, **characterized in that**
the semiconductor subassembly comprises at least three semiconductor chips (2, 2'), which are not arranged in a line, and **in that** the through hole (7) penetrates the plane, in which the at least three semiconductor chips (2, 2') are arranged, within an area (10"), which area (10") lies within an area (10) stretched between the at least three semiconductor chips (2, 2') and excluding those areas, which lie on the border of the area (10) and which are stretched between only two neighbouring semiconductor chips (2, 2').

7. Semiconductor subassembly (13) according to any of the preceding claims, **characterized in that**
the first conductive plate (3) is covered by an insulation layer (12), which is arranged on that side of the first conductive plate (3), which lies opposite the side, on which the at least two semiconductor chips (2, 2') are arranged, and/or **in that** the second conductive plate (4) is covered by an insulation layer (12), which is arranged on that side of the second conductive plate (4), which lies opposite the side, on which the at least two semiconductor chips (2, 2') are arranged.

8. Semiconductor subassembly (13) according to any of the preceding claims, **characterized in that**
at least one of the semiconductor chips (2, 2') comprises a gate electrode (24), which is electrically connected by a gate connection (23), which is lead through the through hole (7).

9. Semiconductor module (1) comprising a compression means (8) and a semiconductor subassembly (13) according to any of the preceding claims.

10. Semiconductor module (1) according to claim 9, **characterized in that**
the compression means (8) comprises an elastical element (81) and a connection element (82), and **in that** the connection element (82) is arranged in the through hole (7).

11. Semiconductor module (1) according to claim 10, **characterized in that**
the elastical element (81) is an elastomer, polymer, plastic, metal or gas spring.

12. Semiconductor module (1) according to claim 10, **characterized in that**
the connection element (82) and / or elastical element (81) is electrically insulated against the semiconductor chips (2, 2') by an insulation element (11).

13. Semiconductor module (1) according to claim 12, **characterized in that**
the insulation element (11) comprises means for enhancing the creepage distance (15).

14. Semiconductor module (1) according to any of the claims 9 to 13, **characterized in that**
the first conductive plate (3) is electrically connected to a first main connection (31), which first main connection (31) is arranged in the same plane as the first conductive plate (3) and/or the second conductive plate (4) is electrically connected to a second main connection (32), which second main connection (32) is arranged in the same plane as the second conductive plate (4).

15. Semiconductor module (1) according to any of the claims 9 to 14, **characterized in that**
the semiconductor module (1) comprises a first cooling plate (51), which is arranged on the first conductive plate (3) on that side, which is opposite the side, on which the at least two semiconductor chips (2, 2') are arranged, and/or
the semiconductor module comprises a second cooling plate (61), which is arranged on the second conductive plate (4) on that side, which is opposite the side, on which the at least two semiconductor chips (2, 2') are arranged, and **in that** the semiconductor subassembly (13) is compressed together with the first and/or second cooling plate (51, 61) by the compression means (8).

16. Semiconductor module (1) according to claim 15, **characterized in that**
the compression means (8) is firmly connected on one side either with the first or second cooling plate (51, 61).

17. Semiconductor module (1) according to any of the claims 9 to 14, **characterized in that**
the semiconductor module (1) comprises a first cooling plate (51), which is arranged on the outside of the semiconductor subassembly (13) on top of the first conductive plate (3),
and **in that** the first cooling plate (51) has projecting portions or recesses, which are in particular spherically formed, and the corresponding first conductive plate (3) has recesses or projecting portions on the side facing the first cooling plate (51),
and **in that** the first cooling plate (51) and the first conductive plate (3) positively fit to each other in the pressure-clamped subassembly (13).

18. Semiconductor module (1) according to any of the claims 9 to 17, **characterized in that**
the semiconductor module comprises a second cooling plate (61), which is arranged on the outside of the semiconductor subassembly (13) on top of the second conductive plate (4),
and **in that** the second cooling plate (61) has projecting portions or recesses, which are in particular spherically formed, and the corresponding second conductive plate (4) has recesses or projecting portions on the side facing the second cooling plate (61), and **in that** the second cooling plate (61) and the second conductive plate (4) positively fit to each other in the pressure-clamped subassembly (13).

19. Semiconductor module (1) according to any of the claims 10 to 13, **characterized in that**
the connection element (82), which is arranged in a through hole (7), and said through hole (7) positively fit, and **in that** the cross-section of the connection element (82) is at least partially not rotation-symmetrically within said through hole (7).

20. Power electronic system, in particular a motor drive, an inverter, a rectifier, a power supply or a power factor controller, comprising a semiconductor module (1) according to any of the claims 9 to 19.
